(19) Europäisches Patentamt
European Patent Office
Office européen des brevets

(11) EP 2 820 436 B1

(12) FASCICULE DE BREVET EUROPEEN

(45) Date de publication et mention
de la délivrance du brevet:
06.04.2016 Bulletin 2016/14

(21) Numéro de dépôt: 13703816.2

(22) Date de dépôt: 13.02.2013

(51) Int Cl.:
*G01R 31/02* $^{(2006.01)}$    *G01R 31/11* $^{(2006.01)}$

(86) Numéro de dépôt international:
PCT/EP2013/052836

(87) Numéro de publication internationale:
WO 2013/127630 (06.09.2013 Gazette 2013/36)

(54) **PROCEDE DE MESURE DU VIEILLISSEMENT DE CABLES ELECTRIQUES**

VERFAHREN ZUR MESSUNG DER ALTERUNG VON ELEKTRISCHEN KABELN

METHOD OF MEASURING THE AGEING OF ELECTRIC CABLES

(84) Etats contractants désignés:
AL AT BE BG CH CY CZ DE DK EE ES FI FR GB
GR HR HU IE IS IT LI LT LU LV MC MK MT NL NO
PL PT RO RS SE SI SK SM TR

(30) Priorité: 29.02.2012 FR 1251822

(43) Date de publication de la demande:
07.01.2015 Bulletin 2015/02

(73) Titulaire: **Commissariat à l'Énergie Atomique
et aux Énergies Alternatives**
**75015 Paris (FR)**

(72) Inventeurs:
• **AUZANNEAU, Fabrice**
**F-91300 Massy (FR)**
• **ELSAHMARANY, Lola**
**F-94230 Cachan (FR)**

(74) Mandataire: **Hammes, Pierre**
**Marks & Clerk France**
**Immeuble Visium**
**22, avenue Aristide Briand**
**94117 Arcueil Cedex (FR)**

(56) Documents cités:
**GB-A- 2 456 205    US-A1- 2004 183 544**

**Description**

L'invention concerne un procédé de mesure du vieillissement d'au moins un câble électrique et s'applique notamment aux domaines de la réflectométrie et du diagnostic de câbles.

Les câbles électriques sont omniprésents dans tous les systèmes électriques, pour l'alimentation ou la transmission d'informations. Pour rappel un câble électrique est habituellement constitué de deux conducteurs métalliques qui suivent le même trajet. Un câble peut être isolé ou placé au sein d'un toron. Ces câbles sont soumis aux mêmes contraintes que les systèmes qu'ils relient et peuvent être sujets à des défaillances ou une dégradation lente. Dans de nombreuses applications, il est donc nécessaire de pouvoir tester l'état de ces câbles et leur niveau de vieillissement.

A titre d'illustration, les câbles qui courent le long des voies ferrées véhiculent des commandes pour les signalisations destinées au trafic ferroviaire. Ils sont très importants et leur utilisation est critique pour le bon fonctionnement du réseau ferré. Une panne peut avoir des répercussions sur une grande partie du réseau ferré et pour conséquences des arrêts ou des retards de trains pouvant s'accumuler et entraîner d'autres retards. Ces câbles sont habituellement longs et sont soumis aux effets des intempéries, aspersions ou à des effets mécaniques comme par exemple aux vibrations au passage des trains ou des glissements de terrain. Ils vieillissent alors rapidement malgré des protections telles que des gaines métalliques ou des gaines élastomères.

Dans les centrales nucléaires, des câbles électriques sont soumis à des rayonnements ionisants qui agressent aussi bien les isolants que le métal et entraînent à la longue une dégradation des qualités de transmission de signaux et une moindre résistance à un accident. Bien qu'ils soient soumis au rayonnement, ces câbles doivent pouvoir résister à des conditions accidentelles telles qu'une irradiation massive sur un temps très court afin de pouvoir continuer à assurer leur fonction. En effet, cette fonction peut être critique comme par exemple le support de signaux de contrôle pour ordonner des actions suite à un accident, comme la libération de barres de contrôle destinées à stopper les réactions en chaîne.

Dans tous ces exemples, la connaissance de l'état de vieillissement du câble permet d'anticiper le remplacement des câbles susceptibles de ne plus fonctionner normalement.

La méthode dite de réflectométrie est la méthode la plus répandue et la plus efficace pour résoudre le problème de la connaissance de l'état de vieillissement. Cette méthode utilise un principe proche de celui du radar. Un signal électrique, souvent de haute fréquence ou de large bande, est injecté en un ou plusieurs endroits du câble sous test. Ce signal se propage dans le câble ou le réseau et renvoie une partie de son énergie lorsqu'il rencontre une discontinuité électrique. Une discontinuité électrique correspond par exemple à un branchement, à la fin du câble ou à un défaut. L'analyse des signaux renvoyés au point d'injection permet d'en déduire des informations sur la présence et la localisation de ces discontinuités et donc des défauts éventuels.

Dans son utilisation usuelle, la méthode de réflectométrie est particulièrement adaptée pour déceler et localiser un défaut localisé en un ou plusieurs points le long d'un câble. Dans le cas d'un vieillissement global du câble, elle n'apporte pas d'information pertinente.

Dans la suite de la description, le terme vieillissement désigne la modification des paramètres électriques ou des caractéristiques physiques le long d'un câble ou d'un ensemble de câbles, et ce de manière homogène ou non. Le terme défaut désigne une modification localisée de ces paramètres, c'est-à-dire dans une zone de faible extension par rapport à la longueur du câble.

On connaît par ailleurs les méthodes décrites dans les documents US2004/183544 et GB2456205 qui adressent un problème similaire.

Un but de l'invention est notamment de pallier les inconvénients des méthodes d'évaluation connues.

A cet effet l'invention a pour objet un procédé d'évaluation du vieillissement d'un ensemble d'au moins un câble électrique comprenant :

- une étape d'injection à un instant Tinj d'un signal de référence Sar en un point d'injection dudit ensemble, ledit signal de référence ayant été obtenu au préalable par injection d'un signal initial Sinit au niveau du point d'injection en un instant Tinit, par une mesure du signal réfléchi résultant de cette injection, et par l'inversion temporelle dudit signal mesuré ;
- une étape de mesure d'un signal réfléchi Smes résultant de la propagation du signal Sar dans l'ensemble d'au moins un câble ;
- une étape de détermination du vieillissement de l'ensemble d'au moins un câble entre l'instant Tinit et l'instant Tinj, ledit vieillissement étant déduit de la mesure du signal réfléchi Smes.

Le vieillissement est par exemple mesuré pour un câble unique, le signal initial et le signal de référence étant injectés dans ce câble.

Le vieillissement d'ensemble d'au moins deux câbles d'un toron étant estimé, les câbles étant répartis sur au moins deux niveaux dont l'usure évolue différemment, le signal initial Sinit et le signal de référence Sar sont par exemple respectivement injectés dans un premier et dans un second câble appartenant à deux niveaux distincts.

Dans un mode de mise en oeuvre possible, un coefficient d'asymétrie CA du signal est déterminé, ledit coefficient étant choisi de manière à ce qu'il prenne une valeur déterminée lorsque le signal Smes est symétrique par rapport à une droite verticale passant par son maximum et dont la valeur s'écarte de cette valeur prédéterminée lorsque le signal Smes n'est pas symétrique, le niveau de vieillissement du câble étant déduit de la valeur du coefficient.

Le coefficient d'asymétrie CA est par exemple égal au rapport entre les surfaces situées de part et d'autre de la verticale passant par le maximum du signal Smes.

Le coefficient d'asymétrie CA est par exemple un rapport entre deux longueurs (d1, d2) associées à deux segments de droite, le premier segment de droite étant défini par l'intersection d'une horizontale positionnée à une hauteur h de l'axe des amplitudes (A) avec une verticale passant par le maximum du signal Smes et par une première intersection de ladite horizontale avec la courbe du signal Smes, le second segment de droite étant défini par l'intersection de l'horizontale avec la verticale et par une seconde intersection de ladite horizontale avec la courbe du signal Smes.

Le coefficient d'asymétrie CA est par exemple calculé dans ce cas en comparant les moyennes de la dérivée obtenue des côtés du signal Smes situés à droite et à gauche de la verticale passant par le maximum de la courbe Smes, et ce entre deux valeurs d'ordonnées

Le coefficient d'asymétrie est par exemple déterminé en comparant les pentes du signal Smes prises à une même hauteur h' de l'axe des amplitudes d'un côté et de l'autre de la verticale passant par le maximum du signal Smes.

Dans un mode de réalisation particulier un premier signal réfléchi Smes est mesuré sur la base de l'injection d'un signal initial Sinit et d'un signal de référence Sar à des instants Tinit et Tinj rapprochés de sorte que le vieillissement du câble ne soit pas perceptible durant cet l'intervalle de temps entre ces deux échantillons, un second signal réfléchi Smes' est mesuré sur la base de l'injection du même signal initial Sinit et d'un signal de référence Sar' à des instants rapprochés Tinit' et Tinj', le vieillissement de l'ensemble de câbles entre les instants Tinj et Tinj' étant déduit du signal résultant de la différence entre les signaux Smes et Smes'.

La mesure du signal réfléchi Smes résulte par exemple de la propagation du signal Sar sur plusieurs trajets aller-retour.

L'invention a également pour objet un dispositif de diagnostic du vieillissement d'un ensemble d'au moins un câble mettant en oeuvre le procédé tel que décrit précédemment.

L'invention a également pour objet un système de mesure du vieillissement d'un ensemble d'au moins un câble comprenant un dispositif de diagnostic tel que décrit précédemment et une bague métallique ou ferromagnétique pour créer une discontinuité de propagation dans l'ensemble d'au moins un câble dont le vieillissement doit être estimé.

D'autres caractéristiques et avantages de l'invention apparaîtront à l'aide de la description qui suit donnée à titre illustratif et non limitatif, faite en regard des dessins annexés parmi lesquels :

- la figure 1 donne un exemple de signal de réflectométrie injecté dans un câble ainsi qu'un signal de retour ;
- la figure 2 illustre le retournement du signal renvoyé par un câble pris dans un état de référence ;
- la figure 3 donne un exemple de signal mesuré en réponse à l'injection du signal Sar lorsque le câble est dans son état de référence ;
- la figure 4 illustre l'évolution de l'asymétrie du signal mesuré suite à l'injection du signal adapté retourné Sar pour différents niveaux de vieillissement d'un câble ;
- la figure 5 représente schématiquement les différentes étapes d'un procédé de mesure de vieillissement d'un ensemble d'au moins un câble ;
- les figures 6 à 9 donnent quatre exemples de méthodes permettant de déterminer le coefficient d'asymétrie utilisé par le procédé de mesure du vieillissement de câbles ;
- les figures 10a et 10b donne deux exemples de torons ;
- la figure 11 donne un exemple d'application du procédé de mesure de vieillissement à un toron comprenant plusieurs niveaux de câbles ;
- la figure 12 illustre le fait que deux signaux mesurés générés à partir de deux signaux de référence distincts peuvent être utilisés pour estimer le vieillissement d'un câble.

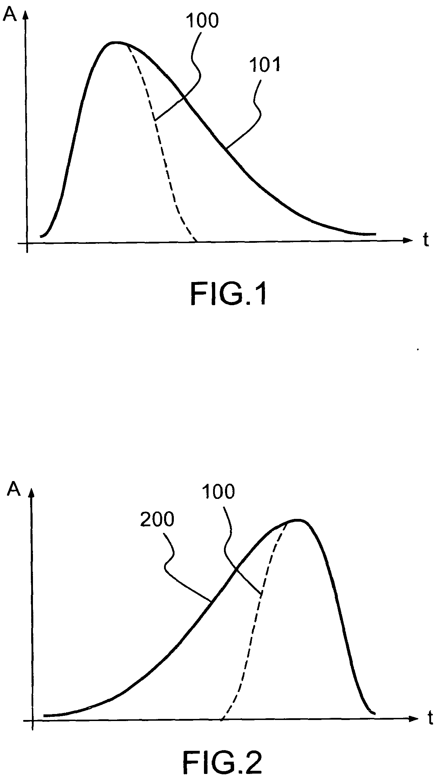

La figure 1 donne un exemple de signal de réflectométrie injecté dans un câble ainsi qu'un signal de retour.

La réflectométrie classique dans le domaine temporel consiste à injecter un signal donné, par exemple un pulse Gaussien, un rectangle ou un échelon de tension. Les signaux renvoyés par le câble sont ensuite analysés.

Le principe du procédé de mesure du vieillissement d'au moins un câble électrique décrit en détails ci-après est le suivant. Une première mesure de réflectométrie est réalisée sur un câble ou un ensemble de câbles pris dans un état de référence. Un exemple d'état de référence est quand le câble est pris dans un état neuf ou non vieilli.

Un signal initial Sinit est injecté dans le câble et le signal renvoyé par le câble est mémorisé. Dans l'exemple de la figure 1, ce signal est un pulse gaussien symétrique 100. Le signal renvoyé 101 par le câble n'est pas une simple copie du signal injecté Sinit. En effet, celui-ci a été modifié par sa propagation dans le câble du fait des phénomènes de filtrage, d'atténuation et de dispersion. Le câble a en quelque sorte apposé sa signature sur le signal renvoyé.

Le signal renvoyé par le câble peut être réutilisé au cours de la vie dudit câble pour estimer son vieillissement. Réutiliser le signal Sinit pendant la vie du câble n'apporterait pas d'information sensible sur le vieillissement car le signal serait choisi a priori, c'est-à-dire sans connaissance particulière du câble concerné. Avantageusement, l'utilisation du signal renvoyé par le câble pris dans un état de référence suite à l'injection de Sinit permet d'estimer finement le vieillissement du câble.

Le signal renvoyé par le câble dans un état de référence suite à l'injection de Sinit est ensuite retourné dans le temps de manière à obtenir un signal dit de référence et noté Sar. La figure 2 illustre le retournement du signal renvoyé par le câble pris dans un état de référence. Le signal Sar 200 peut ensuite être injecté dans le câble à différents instants Tinj de la vie dudit câble.

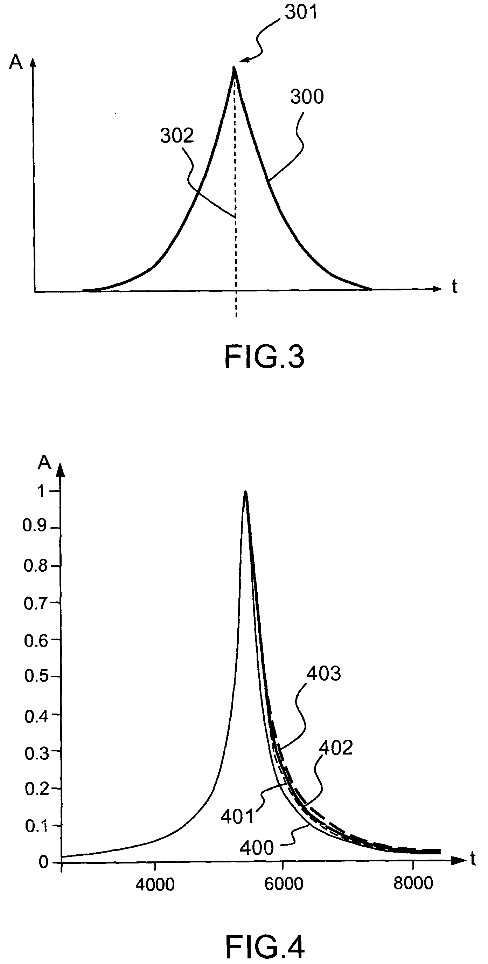

Si le câble est toujours dans son état de référence, le signal qu'il renvoie 300 en réponse à l'injection du signal Sar est symétrique par rapport à un axe vertical passant par son maximum. La figure 3 donne un exemple de signal mesuré 300 en réponse à l'injection du signal Sar lorsque le câble est dans son état de référence. Ce signal est noté Smes.

Par contre, un vieillissement du câble, entraînant une modification des paramètres électriques du câble, va provoquer un changement de sa réponse à l'injection du signal adapté retourné, qui fera apparaitre une dissymétrie dans le signal Smes. On obtiendra alors un signal Smes ressemblant au premier, dont on pourra par exemple mesurer l'asymétrie par rapport à l'axe vertical 302 passant par son maximum 301.

La figure 4 illustre l'évolution de l'asymétrie du signal mesuré suite à l'injection du signal adapté retourné pour différent niveaux de vieillissement d'un câble. Le signal Smes est initialement symétrique 400 lorsque le câble est neuf. Puis celui-ci devient de plus en plus asymétrique 401, 402, 403 lorsque le câble vieillit.

Dans un mode de réalisation, un coefficient d'asymétrie CA est déterminé de manière à faire correspondre la mesure de ce coefficient au vieillissement du câble. Dans le cadre d'une utilisation industrielle, il est alors possible d'effectuer des mesures sur plusieurs câbles avec plusieurs degrés de vieillissement pour relier les valeurs du coefficient d'asymétrie à l'âge ou à la dégradation du câble. De manière alternative, un seuil au-delà ou en dessous duquel on considère que le câble ne peut plus remplir sa mission peut être ainsi déterminé.

Afin de mettre en oeuvre ce procédé, il est possible de mémoriser le signal adapté retourné Sar dans le dispositif de mesure utilisé ou dans un serveur distant. Il est aussi possible de mémoriser les signaux Smes renvoyés par le câble au cours de sa vie. Le procédé peut être mis en oeuvre en embarqué pour une surveillance du câble en continu ou de manière externe par un système que l'on branche sur le câble pour mesurer son vieillissement lors de phases de maintenance par exemple.

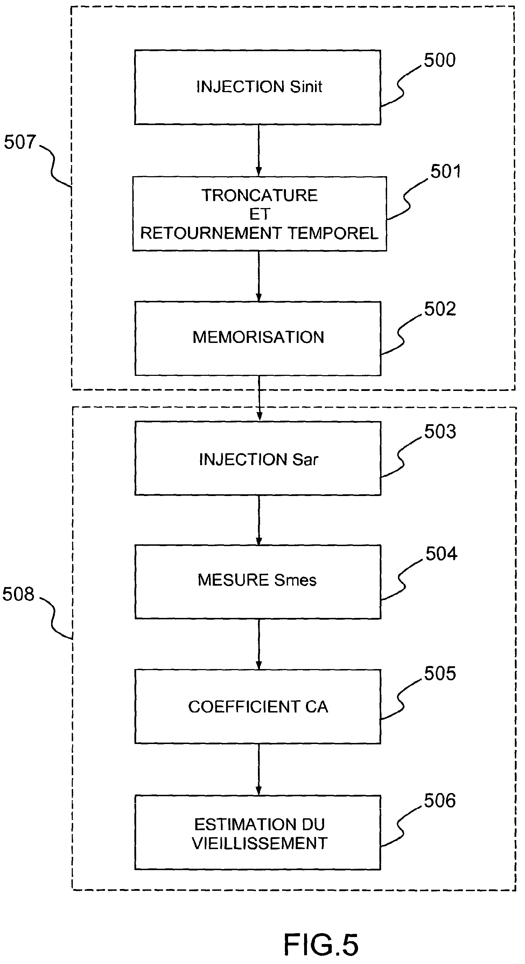

La figure 5 représente schématiquement les différentes étapes du procédé de mesure de vieillissement d'un ensemble d'au moins un câble.

Le procédé permet de mettre en oeuvre une surveillance du vieillissement d'un câble de manière continue ou itérative dans le temps, à partir d'une mesure de référence de signal de référence, c'est-à-dire le signal adapté retourné Sar, établie lorsque le câble est dans un état de référence, par exemple lorsqu'il est neuf. Cette référence peut être toujours la même ou bien mise à jour à différents moments de la vie du câble. Le premier cas est utilisé pour évaluer un vieillissement constant et graduel dans le temps. Le second cas permet de repérer des phases de vieillissement accéléré au cours de la vie du câble.

Le procédé comprend une étape 500 de mesure de réflectométrie initiale. Un signal symétrique tel qu'un pulse gaussien ou un rectangle est injecté à une extrémité du câble ou de l'ensemble de câbles appelé point d'injection. Le signal renvoyé par le câble est ensuite mesuré. Cette mesure est faite avec des paramètres typiques d'une réflectométrie standard.

Le signal réfléchi par cette mesure initiale est tronqué et retourné dans le temps 501 puis mémorisé 502 pour être réutilisé par la suite dans la vie du câble. S'il est très atténué par rapport au signal initial, on peut l'amplifier numériquement, voire le filtrer s'il est bruité ou le normaliser avant de le mémoriser pour une utilisation future. Ce nouveau signal est le signal adapté retourné Sar.

Dans une étape ultérieure 503, le signal Sar ainsi obtenu est injecté au même point d'injection à divers moments de la vie du câble pour effectuer une nouvelle mesure de réflectométrie par exemple avec le même instrument que pour l'étape 501.

Une mesure Smes du signal renvoyée par le câble est acquise et mémorisée 504. Le pulse représentatif de la réflexion à la fin du câble est isolé, puis un coefficient d'asymétrie CA 505 est déterminé. Ce coefficient a pour fonction d'évaluer la différence entre les parties droite et gauche du signal Smes. Ce coefficient CA est par exemple calculé de manière à valoir un pour un signal symétrique.

Les étapes 507 menant à la génération du signal Sar et les étapes 508 menant à l'estimation du vieillissement du câble sont des étapes distinctes pouvant être mises en oeuvre séparément, par exemple dans deux dispositifs différents.

Le coefficient CA est ensuite utilisé pour déterminer le vieillissement du câble. A titre d'exemple, la valeur du coefficient d'asymétrie est reliée au vieillissement du câble par un abaque ou par des caractérisations préalables. Lorsque le câble est neuf, le coefficient CA vaut exactement un. Si le coefficient passe par une valeur seuil décidée à l'avance comme indice de vieillissement maximal, il est alors temps de changer le câble.

Dans un mode de réalisation alternatif, le signal Sar utilisé pour l'acquisition de Smes n'est pas le même à chaque fois mais est celui qui est obtenu en appliquant le retournement temporel au signal mesuré lors de la mesure précédente ou d'une mesure précédemment choisie. En d'autres termes, les différents signaux Sar utilisés correspondent à plusieurs états de référence distincts. Les autres étapes sont identiques, avec calcul du coefficient d'asymétrie CA et détection d'un vieillissement par analyse de l'évolution du coefficient au cours de la vie du câble. Dans ce mode de réalisation, le but est de détecter une variation brusque signe d'un vieillissement accéléré causé par une modification brutale des paramètres du câble depuis la mesure de référence précédente.

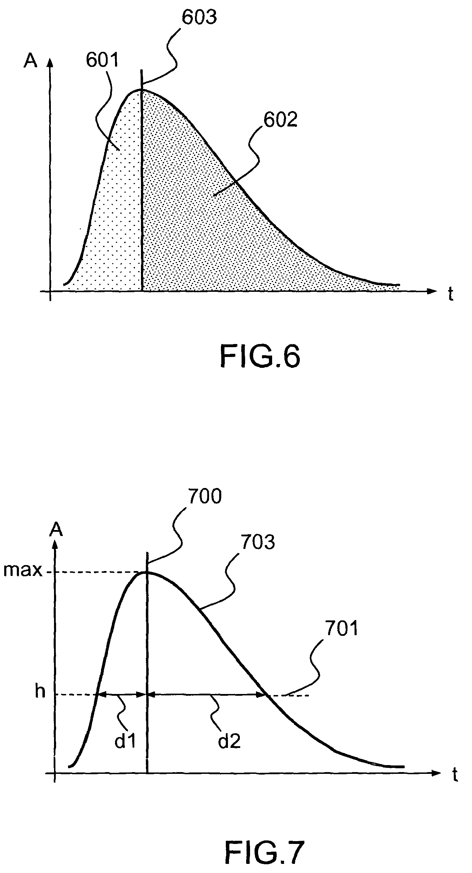

La figure 6 donne un premier exemple de méthode pour déterminer le coefficient d'asymétrie utilisé par le procédé de mesure du vieillissement de câbles. Cette première méthode se base sur la détermination du rapport entre les surfaces 601, 602 situées de part et d'autre de la verticale 603 passant par le maximum du signal Smes. Si le rapport est différent de un, une asymétrie est détectée.

La figure 7 donne un deuxième exemple de méthode pour déterminer le coefficient d'asymétrie utilisé par le procédé de mesure du vieillissement de câbles. Dans ce cas, le coefficient d'asymétrie correspond à un rapport K entre deux longueurs d1 et d2 associées à deux segments. Le premier segment de droite est défini par l'intersection d'une horizontale 701 positionnée à une hauteur h de l'axe des amplitudes A avec une verticale 700 passant par le maximum du signal Smes et par une intersection entre la courbe 703 du signal Smes et ladite horizontale 701. Le second segment de droite est défini par l'intersection de l'horizontale 701 avec ladite verticale 700 et par une seconde intersection de ladite horizontale 701 avec la courbe 703 du signal Smes.

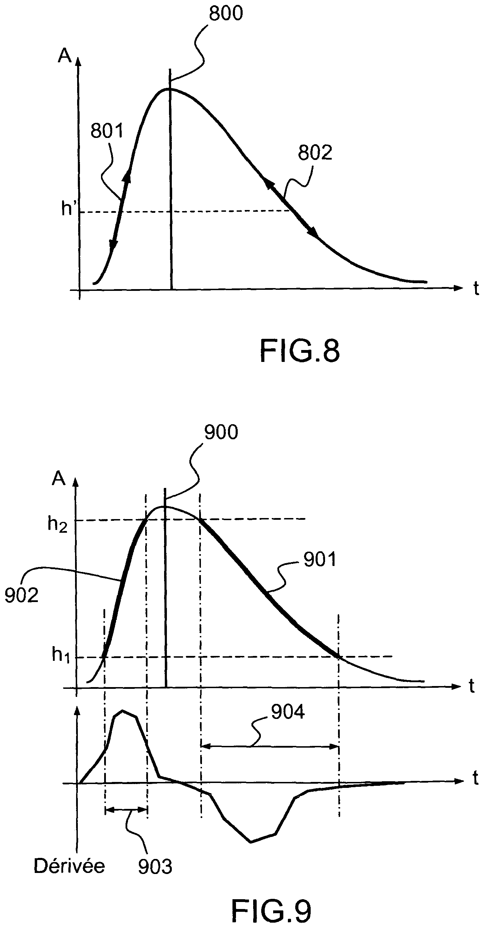

La figure 8 donne un troisième exemple de méthode pour déterminer le coefficient d'asymétrie utilisé par le procédé de mesure du vieillissement de câbles. Le principe est de comparer les pentes 801, 802 du signal prises à une même hauteur h' d'un côté et de l'autre de la verticale 800 passant par le maximum du signal Smes.

Dans ce cas, le coefficient CA peut être choisi comme étant la différence ou le rapport entre les deux pentes, selon qu'on veuille le comparer à un ou à zéro. Ce coefficient peut être calculé à une hauteur donnée h' avec h'=max/2 par exemple, ou bien sommé ou moyenne sur une plage de hauteurs données.

La figure 9 donne un quatrième exemple de méthode pour déterminer le coefficient d'asymétrie utilisé par le procédé de mesure du vieillissement de câbles. Le coefficient d'asymétrie CA est calculé dans ce cas en comparant les moyennes 903, 904 de la dérivée obtenue des côtés de Smes situés à droite 901 et à gauche 902 de la verticale 900 passant par le maximum de la courbe Smes, et ce entre deux valeurs d'ordonnées.

D'autres méthodes de détermination du coefficient d'asymétrie sont également envisageables dans le cadre de l'invention. Dans certaines applications, il peut être nécessaire de définir un coefficient adapté au type de signal mesuré ou de signal injecté pour la mesure de réflectométrie initiale. Un exemple de tel coefficient $\gamma_1$ est le coefficient habituellement désigné par le mot anglais « skewness » et pouvant être défini par l'expression suivante :

$$\gamma_1 = \mathrm{E}\left[\left(\frac{X-\mu}{\sigma}\right)^3\right] = \frac{\mu_3}{\sigma^3} = \frac{\mathrm{E}\left[(X-\mu)^3\right]}{(\mathrm{E}\left[(X-\mu)^2\right])^{3/2}} = \frac{\kappa_3}{\kappa_2^{3/2}} , \tag{1}$$

dans laquelle :

X désigne l'amplitude du signal mesuré ;
$\mu_3$ est le troisième moment centré défini par l'espérance de X-$\mu$ au cube, $\mu$ étant la moyenne de X ;
$\sigma$ est l'écart-type ;
E [ ] désigne l'espérance mathématique.

Pour un signal Smes échantillonné sur n valeurs, un coefficient $g_1$ peut être déterminé en utilisant l'expression suivante :

$$g_1 = \frac{m_3}{m_2^{3/2}} = \frac{\frac{1}{n}\sum_{i=1}^{n}(x_i - \overline{x})^3}{\left(\frac{1}{n}\sum_{i=1}^{n}(x_i - \overline{x})^2\right)^{3/2}} , \tag{2}$$

dans laquelle :

$x_i$ désigne le i-ème échantillon du signal Smes ;

$\bar{x}$ désigne la moyenne des échantillons $x_i$.

Même si les mises en oeuvre décrites précédemment ont été décrites pour un signal initial Sinit symétrique, l'homme du métier peut adapter le procédé pour un signal Sinit non symétrique. Dans ce cas, il faudra non pas comparer la valeur du coefficient CA à des valeurs prédéfinies en utilisant par exemple un abaque, mais comparer l'évolution au cours du temps de ce coefficient pour plusieurs mesures de Smes distinctes et éventuellement les comparer à une ou plusieurs valeurs prédéfinies pour déterminer un niveau de vieillissement.

Le procédé peut être appliqué pour mesurer le vieillissement d'un câble point à point ou d'un câble ramifié. Dans ce dernier cas, plusieurs pulses sont renvoyés suite à une injection du signal Sar, lesdits pulses étant caractéristiques des ramifications et des terminaisons des lignes. On peut alors appliquer le procédé en choisissant la section que l'on veut analyser en sélectionnant le pulse renvoyé par l'extrémité de cette section comme signal de référence. Il faut alors isoler le pulse du signal Smes renvoyé par cette section et appliquer le procédé sur ce pulse uniquement.

Le procédé peut être appliqué à un câble ramifié ou non, subissant un vieillissement uniforme. Il peut être aussi appliqué à un câble subissant un vieillissement qui n'est pas uniforme. Dans ce cas, le procédé s'applique de la même manière. A titre d'exemple, il est possible que vingt-cinq pourcents d'un câble restent presque neuf alors que les soixante-quinze autres pourcents vieillissent plus rapidement. Si le vieillissement du câble n'est pas constant sur sa longueur, mais par exemple qu'une portion vieillit différemment du fait que les conditions environnementales sont différentes, le signal renvoyé par le câble possède des caractéristiques d'asymétrie représentatives du rapport entre les portions neuves et vieillies. L'analyse de l'asymétrie du signal permet dans ce cas d'en déduire la répartition du vieillissement du câble.

Le procédé de mesure de vieillissement peut être appliqué à un câble isolé ou bien à un toron, c'est-à-dire un assemblage de plusieurs câbles.

Les câbles d'un toron peuvent être répartis de manières différentes. Les positions des câbles dans le toron peuvent être aléatoires et changer le long de sa longueur. Dans ce cas, le vieillissement est alors identique pour tous les câbles du toron et on applique le procédé de mesure du vieillissement décrit précédemment à l'un des câbles pour connaître le vieillissement de l'ensemble des câbles du toron.

Alternativement, les positions relatives des câbles dans le toron peuvent être identiques à tout endroit du toron. Deux cas peuvent alors être distingués. Dans un premier cas, tous les câbles du toron sont à l'extérieur. Dans un deuxième cas, certains câbles sont à l'intérieur du toron et d'autres à l'extérieur.

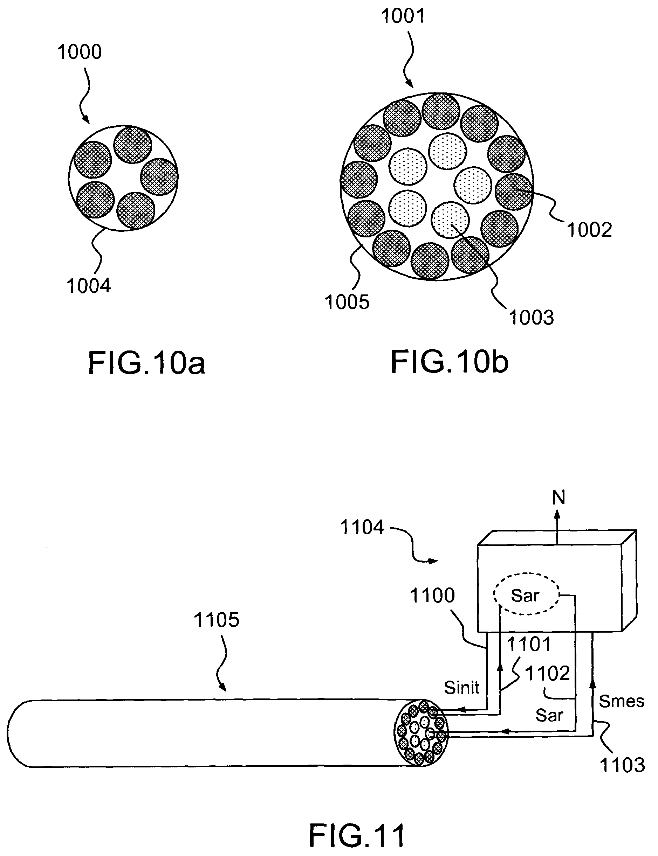

Les figures 10a et 10b donne deux exemples de torons. Un premier exemple de toron 1000 comprend cinq câbles et un second exemple de toron 1001 comprend un niveau externe 1002 comprenant douze câbles et un niveau interne 1003 comprend cinq câbles. Les câbles des deux torons 1000, 1001 sont recouverts par un isolant 1004, 1005.

Pour des torons composés d'un niveau de câble externe et d'au moins un niveau de câble interne, il est habituel que les câbles appartenant au niveau interne soient mieux protégés de l'environnement extérieur que les câbles du niveau externe.

La figure 11 donne un exemple d'application du procédé de mesure de vieillissement à un toron comprenant plusieurs niveaux de câbles.

Une première façon de faire est d'appliquer le procédé indépendamment à un ou plusieurs câbles. Une autre façon de faire est d'appliquer le procédé de manière différentielle comme représenté sur la figure 11. Pour cela, il est possible de comparer le vieillissement entre les câbles de niveaux interne et externe en utilisant comme signal de référence sur un câble du niveau interne le signal adapté retourné Sar d'un câble de niveau externe. Dans un exemple de mise en oeuvre, un dispositif de diagnostic 1104 injecte 1100 dans un câble du niveau externe d'un toron 1105 un signal initial Sinit, mesure le signal renvoyé 1101, en déduit le signal Sar qui est ensuite injecté 1102 dans un câble d'un niveau interne du toron 1105. Le signal réfléchi Smes est ensuite récolté 1103 et mesuré pour permettre l'estimation N du vieillissement du toron 1105. Dans ce cas, le point d'injection correspond à la section du toron au niveau de laquelle les signaux nécessaires à la mise en oeuvre du procédé sont injectés et mesurés.

Il est également possible de comparer le vieillissement des câbles externes à celui des câbles internes d'un même toron en utilisant comme signal de référence sur un câble du niveau externe le signal adapté retourné Sar obtenu à partir d'un câble de niveau interne.

Il est à noter que lorsque le dispositif de diagnostic n'est pas adapté en impédance au câble sous test, le signal qui revient du câble rebondit au niveau de la connexion avec le dispositif de diagnostic et repart dans le câble. Cela se traduit dans la mesure du signal Sinit modifié suite à sa réflexion dans le câble par des pulses supplémentaires au-delà du pulse principal renvoyé. Ces pulses correspondent à des signaux ayant parcouru une distance plus importante égale à un multiple entier de la distance aller-retour dans le câble. Ainsi, dans un mode de réalisation, ces signaux supplémentaires peuvent être utilisés pour former le signal adapté retourné Sar.

Il est en outre connu que le vieillissement d'un câble se traduit par une modification de la vitesse de propagation des signaux. En général cette modification correspond à une diminution de cette vitesse. On peut alors utiliser cette information de modification de la vitesse de propagation en parallèle avec les mesures obtenues par le procédé décrit précédemment afin de raffiner l'estimation du vieillissement du câble. Pour cela, une estimation du décalage dans le temps relatif des signaux en provenance des câbles neufs par rapport aux signaux en provenance des câbles vieillis peut être utilisée.

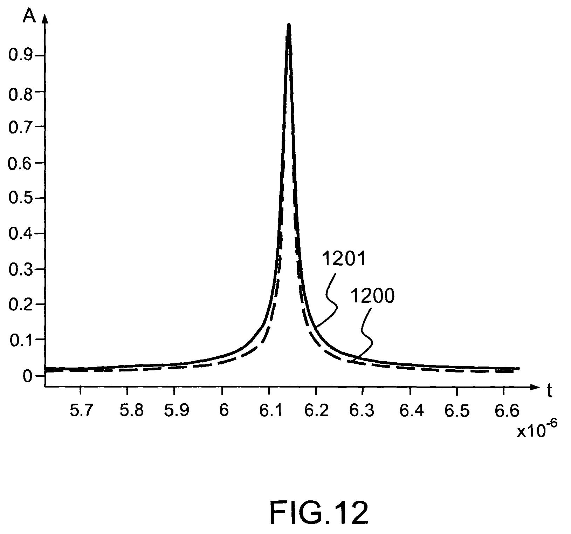

Par ailleurs, le calcul du coefficient d'asymétrie CA peut être remplacé par une autre technique. En référence à la figure 12, on peut par exemple faire la différence entre le signal 1200 acquis Smes1 pour le câble neuf après injection du signal adapté retourné Sar avec le signal Smes2 1201 obtenu au cours de la vie du câble. Les maxima de ces deux signaux peuvent être calés au même instant, en décalant l'un des signaux, par exemple celui du câble vieilli, et de faire la différence des deux. Un indicateur de vieillissement possible est alors l'aire sous la courbe de valeur absolue de cette différence.

Il est bien connu que certains câbles présentent une forte absorption des hautes fréquences de par leurs caractéristiques physiques ou leur grande longueur. Le procédé de mesure de vieillissement proposé est alors difficile à mettre en oeuvre car la dispersion du signal que l'on cherche à mettre en évidence est visible habituellement grâce aux hautes fréquences dans le spectre des signaux. Une manière de pallier à ce problème est d'ajouter à un endroit autour du câble une bague métallique ou ferromagnétique dont la fonction est de créer une discontinuité de propagation afin de renvoyer un signal vers le point d'injection. Une longueur plus petite de câble est ainsi simulée. Il en résulte une atténuation de propagation moins importante. L'application du procédé de mesure du vieillissement reste inchangée.

Dans un mode de réalisation, plusieurs trajets aller-retour peuvent être utilisés au lieu d'un seul. Cela a pour effet d'augmenter la dissymétrie du signal Smes entre un câble neuf et un câble usagé.

On peut aussi appliquer le procédé au câble neuf en y injectant le signal Sinit afin d'obtenir un signal symétrique de référence Sar, puis renouveler l'opération en injectant le signal Sinit au câble vieilli ce qui fournira un deuxième signal symétrique Sar'. On compare alors les deux signaux obtenus Smes et Smes', la différence portant surtout sur l'amplitude maximale et l'écartement des branches du signal par rapport à l'axe de symétrie. Si les deux signaux Smes et Smes' sont normalisés pour que le maximum soit à une valeur arbitraire de un, c'est la différence de largeur qui est le critère de vieillissement.

## Revendications

1.   Procédé d'évaluation du vieillissement d'un ensemble d'au moins un câble électrique comprenant :

   - une étape (503) d'injection à un instant Tinj d'un signal de référence Sar en un point d'injection dudit ensemble, ledit signal de référence (200) ayant été obtenu au préalable par injection (500) d'un signal initial Sinit (100) au niveau du point d'injection en un instant Tinit, par une mesure (101) du signal réfléchi résultant de cette injection, et par l'inversion temporelle (501) dudit signal mesuré (101);
   - une étape (504) de mesure d'un signal réfléchi Smes résultant de la propagation du signal Sar dans l'ensemble d'au moins un câble ;
   - une étape (505, 506) de détermination du vieillissement de l'ensemble d'au moins un câble entre l'instant Tinit et l'instant Tinj, ledit vieillissement étant déduit de la mesure du signal réfléchi Smes.

2.   Procédé selon la revendication 1 dans lequel le vieillissement est mesuré pour un câble unique, le signal initial et le signal de référence étant injectés dans ce câble.

3.   Procédé selon la revendication 1 dans lequel le vieillissement d'ensemble d'au moins deux câbles (1105) d'un toron est estimé, les câbles étant répartis sur au moins deux niveaux dont l'usure évolue différemment, le signal initial Sinit (1100) et le signal de référence Sar (1102) étant respectivement injectés dans un premier et dans un second câble appartenant à deux niveaux distincts.

4.   Procédé selon l'une des revendications précédentes dans lequel un coefficient d'asymétrie CA du signal est déterminé, ledit coefficient étant choisi de manière à ce qu'il prenne une valeur déterminée lorsque le signal Smes est symétrique par rapport à une droite verticale passant par son maximum et dont la valeur s'écarte de cette valeur prédéterminée lorsque le signal Smes n'est pas symétrique, le niveau de vieillissement du câble étant déduit de la valeur du coefficient.

5.   Procédé selon la revendication 4 dans lequel le coefficient d'asymétrie CA est égal au rapport entre les surfaces (601, 602) situées de part et d'autre de la verticale (603) passant par le maximum du signal Smes.

**6.** Procédé selon la revendication 4 dans lequel le coefficient d'asymétrie CA est un rapport entre deux longueurs (d1, d2) associées à deux segments de droite, le premier segment de droite étant défini par l'intersection d'une horizontale (701) positionnée à une hauteur h de l'axe des amplitudes (A) avec une verticale (700) passant par le maximum (max) du signal Smes et par une première intersection de ladite horizontale avec la courbe (703) du signal Smes, le second segment de droite étant défini par l'intersection de l'horizontale (701) avec la verticale (700) et par une seconde intersection de ladite horizontale avec la courbe (703) du signal Smes.

**7.** Procédé selon la revendication 4 dans lequel le coefficient d'asymétrie CA est calculé dans ce cas en comparant les moyennes (903, 904) de la dérivée obtenue des côtés du signal Smes situés à droite (901) et à gauche (902) de la verticale (900) passant par le maximum de la courbe Smes, et ce entre deux valeurs d'ordonnées

**8.** Procédé selon la revendication 4 dans lequel le coefficient d'asymétrie est déterminé en comparant les pentes (801, 802) du signal Smes prises à une même hauteur h' de l'axe des amplitudes d'un côté et de l'autre de la verticale (800) passant par le maximum du signal Smes.

**9.** Procédé selon l'une des revendications précédentes dans lequel un premier signal réfléchi Smes est mesuré sur la base de l'injection d'un signal initial Sinit et d'un signal de référence Sar à des instants Tinit et Tinj rapprochés de sorte que le vieillissement du câble ne soit pas perceptible durant cet l'intervalle de temps entre ces deux échantillons, un second signal réfléchi Smes' est mesuré sur la base de l'injection du même signal initial Sinit et d'un signal de référence Sar' à des instants rapprochés Tinit' et Tinj', le vieillissement de l'ensemble de câbles entre les instants Tinj et Tinj' étant déduit du signal résultant de la différence entre les signaux Smes et Smes'.

**10.** Procédé selon l'une quelconque des revendications précédentes, **caractérisé en ce que** la mesure du signal réfléchi Smes résulte de la propagation du signal Sar sur plusieurs trajets aller-retour.

**11.** Dispositif de diagnostic du vieillissement d'un ensemble d'au moins un câble dans lequel le procédé selon l'une des revendications précédentes est mis en oeuvre.

**12.** Système de mesure du vieillissement d'un ensemble d'au moins un câble comprenant un dispositif de diagnostic selon la revendication 11 et une bague métallique ou ferromagnétique pour créer une discontinuité de propagation dans l'ensemble d'au moins un câble dont le vieillissement doit être estimé.

**Patentansprüche**

**1.** Verfahren zum Beurteilen des Alterns einer Baugruppe von wenigstens einem elektrischen Kabel, das Folgendes beinhaltet:

- einen Schritt (503) des Injizierens eines Referenzsignals Sar zu einem Zeitpunkt Tinj an einem Injektionspunkt der Baugruppe, wobei das Referenzsignal (200) zuvor durch Injizieren (500) eines Anfangssignals Sinit (100) am Injektionspunkt zu einem Zeitpunkt Tinit, durch Messen (101) des von dieser Injektion resultierenden reflektierten Signals und durch zeitliches Invertieren (501) des gemessenen Signals (101) erhalten wurde;
- einen Schritt (504) des Messens eines von der Ausbreitung des Signals Sar resultierenden reflektierten Signals Smes in dem gesamten wenigstens einen Kabel;
- einen Schritt (505, 506) des Ermitteins des Alterns der Gesamtheit von wenigstens einem Kabel zwischen dem Zeitpunkt Tinit und dem Zeitpunkt Tinj, wobei das Altern vom Messwert des reflektierten Signals Smes abgeleitet wird.

**2.** Verfahren nach Anspruch 1, wobei das Altern für ein einzelnes Kabel gemessen wird, wobei das Anfangssignal und das Referenzsignal in dieses Kabel injiziert werden.

**3.** Verfahren nach Anspruch 1, wobei das Altern der Gesamtheit von wenigstens zwei Kabeln (1105) eines Strangs geschätzt wird, wobei die Kabel über wenigstens zwei Ebenen verteilt sind, deren Verschleiß unterschiedlich verläuft, wobei das Anfangssignal Sinit (1100) und das Referenzsignal Sar (1102) jeweils in ein erstes und ein zweites Kabel injiziert werden, die zu zwei unterschiedlichen Ebenen gehören.

**4.** Verfahren nach einem der vorherigen Ansprüche, in dem ein Asymmetriekoeffizient CA des Signals ermittelt wird, wobei der Koeffizient so gewählt wird, dass er einen bestimmten Wert annimmt, wenn das Signal Smes relativ zu einer vertikalen Linie symmetrisch ist, die durch sein Maximum verläuft, und dessen Wert von diesem vorbestimmten Wert abweicht, wenn das Signal Smes nicht symmetrisch ist, wobei das Alterungsniveau des Kabels von dem Wert des Koeffizienten abgeleitet wird.

5. Verfahren nach Anspruch 4, wobei der Asymmetriekoeffizient CA gleich dem Verhältnis zwischen den Flächen (601, 602) ist, die sich auf beiden Seiten der vertikalen Linie (603) befinden, die durch das Maximum des Signals Smes verläuft.

6. Verfahren nach Anspruch 4, wobei der Asymmetuekoeffizient CA ein Verhältnis zwischen zwei mit zwei Geradenabschnitten assoziierten Längen (d1, d2) ist, wobei der erste Geradenabschnitt durch den Schnittpunkt einer Horizontalen (701), die sich in einer Höhe h der Achse der Amplituden (A) befindet, mit einer vertikalen Linie (700), die durch das Maximum (max) des Signals Smes verläuft, und durch einen ersten Schnittpunkt der horizontalen Linie mit der Kurve (703) des Signals Smes definiert wird, wobei der zweite Geradenabschnitt vom Schnittpunkt der horizontalen Linie (701) mit der vertikalen Linie (700) und durch einen zweiten Schnittpunkt der horizontalen Linie mit der Kurve (703) des Signals Smes definiert wird.

7. Verfahren nach Anspruch 4, wobei der Asymmetriekoeffizient CA in diesem Fall durch Vergleichen der Durchschnitte (903, 904) der Abweichung berechnet wird, die auf den Seiten des Signals Smes rechts (901) und links (902) von der vertikalen Linie (900) erhalten wird, die durch das Maximum der Kurve Smes verläuft, und dies zwischen zwei Ordinatenwerten.

8. Verfahren nach Anspruch 4, wobei der Asymmetriekoeffizient CA durch Vergleichen der Steigungen (801, 802) des Signals Smes auf derselben Höhe h' der Achse der Amplituden auf der Seite und der anderen Seite der durch das Maximum des Signals Smes verlaufenden vertikalen Linie (800) ermittelt wird.

9. Verfahren nach einem der vorherigen Ansprüche, wobei ein erstes reflektiertes Signal Smes auf der Basis der Injektion eines Anfangssignals Sinit und eines Referenzsignals Sar an nahe gelegenen Zeitpunkten Tinit und Tinj gemessen wird, so dass die Alterung des Kabels während dieses Zeitintervalls zwischen diesen beiden Samples nicht wahrnehmbar ist, ein zweites reflektiertes Signal Smes' auf der Basis der Injektion des selben Anfangssignals Sinit und eines Referenzsignals Sar' an nahe gelegenen Zeitpunkten Tinit' und Tinj' gemessen wird, wobei die Alterung der Gesamtheit von Kabeln zwischen den Zeitpunkten Tinj und Tinj' von dem von der Differenz zwischen den Signalen Smes und Smes' resultierenden Signal abgeleitet wird.

10. Verfahren nach einem der vorherigen Ansprüche, **dadurch gekennzeichnet, dass** der Messwert des reflektierten Signals Smes von der Ausbreitung des Signals Sar über mehrere Hin- und Rückwege resultiert.

11. Vorrichtung zum Diagnostizieren des Alterns der Gesamtheit von wenigstens einem Kabel, wobei das Verfahren gemäß einem der vorherigen Ansprüche implementiert wird.

12. System zum Messen der Alterung der Gesamtheit von wenigstens einem Kabel, umfassend eine Diagnostikvorrichtung nach Anspruch 11 und einen metallischen oder ferromagnetischen Ring zum Erzeugen einer Diskontinuität der Ausbreitung in der Gesamtheit von wenigstens einem Kabel, dessen Alterung geschätzt werden soll.

**Claims**

1. A method for assessing the ageing of an assembly of at least one electric cable, comprising:

    - a step (503) of injecting a reference signal Sar at an instant Tinj at an injection point of said assembly, said reference signal (200) having been previously obtained by injecting (500) an initial signal Sinit (100) at said injection point at an instant Tinit, by measuring (101) the reflected signal resulting from this injection and by temporally inverting (501) said measured signal (101);
    - a step (504) of measuring a reflected signal Smes resulting from the propagation of said signal Sar through the assembly of at least one cable;
    - a step (505, 506) of determining the ageing of the assembly of at least one cable between the instant Tinit and the instant Tinj, said ageing being deduced from the measurement of the reflected signal Smes.

2. The method according to claim 1, wherein the ageing is measured for a single cable, said initial signal and said reference signal being injected into said cable.

3. The method according to claim 1, wherein the ageing of the assembly of at least two cables (1105) of a strand is estimated, said cables being distributed over at least two levels, the wear of which develops differently, said initial signal Sinit (1100) and said reference signal Sar (1102) being respectively injected into a first and into a second cable belonging to two distinct levels.

4. The method according to any one of the preceding claims, wherein an asymmetry coefficient CA of the signal is determined, said coefficient being selected so that it assumes a determined value when said signal Smes is symmetrical relative to a vertical line passing through its maxima and for which the value deviates from this predetermined value when said signal Smes is not symmetrical, the level of ageing of said cable being deduced from the value of said coefficient.

5. The method according to claim 4, wherein said asymmetry coefficient CA is equal to the ratio between the surfaces (601, 602) located on either side of the vertical line (603) passing through the maxima of said signal Smes.

6. The method according to claim 4, wherein said asymmetry coefficient CA is a ratio between two lengths (d1, d2) associated with two straight segments, the first straight segment being defined by the intersection of a horizontal line (701) positioned at a height h of the axis of the amplitudes (A) with a vertical line (700) passing through the maxima (max) of said signal Smes and through a first intersection of said horizontal line with the curve (703) of said signal Smes, the second straight segment being defined by the intersection of the horizontal line (701) with the vertical line (700) and by a second intersection of said horizontal line with the curve (703) of said signal Smes.

7. The method according to claim 4, wherein said asymmetry coefficient CA in this case is computed by comparing the averages (903, 904) of the shift obtained on the sides of said signal Smes located to the right (901) and to the left (902) of the vertical line (900) passing through the maxima of the curve Smes, and this between two ordinate values.

8. The method according to claim 4, wherein said asymmetry coefficient CA is determined by comparing the pitches (801, 802) of said signal Smes taken at the same height h' of the axis of the amplitudes on one side and on the other side of the vertical line (800) passing through the maxima of said signal Smes.

9. The method according to any one of the preceding claims, wherein a first reflected signal Smes is measured on the basis of the injection of an initial signal Sinit and of a reference signal Sar at close instants Tinit and Tinj, so that the ageing of the cable is not perceptible during this time interval between these two samples, a second reflected signal Smes' is measured on the basis of the injection of the same initial signal Sinit and of a reference signal Sar' at close instants Tinit' and Tinj', with the ageing of the assembly of cables between the instants Tinj and Tinj' being deduced from the signal resulting from the difference between the signals Smes and Smes'.

10. The method according to any one of the preceding claims, **characterised in that** the measurement of the reflected signal Smes results from the propagation of the signal Sar over a plurality of outward-return paths.

11. A device for diagnosing the ageing of an assembly of at least one cable, wherein the method according to any one of the preceding claims is implemented.

12. A system for measuring the ageing of an assembly of at least one cable comprising a diagnostic device according to claim 11 and a metallic or ferromagnetic ring for generating a discontinuity in the propagation in the assembly of at least one cable for which ageing must be estimated.

FIG.1

FIG.2

FIG.3

FIG.4

```
┌─────────────────────────────────────────────────────────┐
│                                                          │
│            ┌──────────────────────────┐   ╭── 500        │
│            │    INJECTION Sinit        │                 │
│            └──────────────────────────┘                 │
│                        │                                 │
│  507 ╮                 ▼                                 │
│      ╰     ┌──────────────────────────┐   ╭── 501        │
│            │      TRONCATURE           │                 │
│            │          ET               │                 │
│            │  RETOURNEMENT TEMPOREL     │                 │
│            └──────────────────────────┘                 │
│                        │                                 │
│                        ▼                                 │
│            ┌──────────────────────────┐   ╭── 502        │
│            │      MEMORISATION         │                 │
│            └──────────────────────────┘                 │
│                                                          │
└─────────────────────────────────────────────────────────┘
                         │
┌────────────────────────▼────────────────────────────────┐
│                                                          │
│            ┌──────────────────────────┐   ╭── 503        │
│            │     INJECTION Sar         │                 │
│            └──────────────────────────┘                 │
│                        │                                 │
│                        ▼                                 │
│            ┌──────────────────────────┐   ╭── 504        │
│  508 ╮     │     MESURE Smes           │                 │
│      ╰     └──────────────────────────┘                 │
│                        │                                 │
│                        ▼                                 │
│            ┌──────────────────────────┐   ╭── 505        │
│            │     COEFFICIENT CA        │                 │
│            └──────────────────────────┘                 │
│                        │                                 │
│                        ▼                                 │
│            ┌──────────────────────────┐   ╭── 506        │
│            │     ESTIMATION DU          │                 │
│            │     VIEILLISSEMENT        │                 │
│            └──────────────────────────┘                 │
│                                                          │
└─────────────────────────────────────────────────────────┘
```

FIG.5

FIG.6

FIG.7

FIG.8

Dérivée        903

FIG.9

**FIG.10a**

**FIG.10b**

**FIG.11**

FIG.12

**EP 2 820 436 B1**

## RÉFÉRENCES CITÉES DANS LA DESCRIPTION

**Documents brevets cités dans la description**

- US 2004183544 A

- GB 2456205 A